# EUROPEAN PATENT APPLICATION

(11) **EP 3 937 194 A1**
(43) Date of publication of application: **12.01.2022**
(21) Application number: 20766384.0
(22) Date of filing: 28.02.2020
(51) Int. Cl.: H01F 1/11, B82Y 25/00, B82Y 40/00, C01G 49/00, C01G 51/00, G11B 5/706, G11B 5/842, H01F 1/113

(54) **SUBSTITUTION-TYPE EPSILON-IRON OXIDE MAGNETIC PARTICLE POWDER, METHOD FOR PRODUCING SUBSTITUTION-TYPE EPSILON-IRON OXIDE MAGNETIC PARTICLE POWDER, GREEN COMPACT, METHOD FOR PRODUCING GREEN COMPACT, AND ELECTROMAGNETIC WAVE ABSORBER**

(30) Priority: 05.03.2019 JP 2019040063; 30.09.2019 JP 2019180329
(71) Applicant: DOWA Electronics Materials Co., Ltd., Tokyo 101-0021 (JP)
(72) Inventor: HORI, Tatsuro, Tokyo 101-0021 (JP); KODAMA, Daisuke, Tokyo 101-0021 (JP); OBATA, Shiho, Sendai-shi, Miyagi 980-0871 (JP); GOTOH, Masahiro, Tokyo 101-0021 (JP)
(74) Representative: Klang, Alexander H.
(86) International application number: PCT/JP2020/008278
(87) International publication number: WO 2020/179659

(57) **Abstract**

[Problem] To provide a substitution-type ε-iron oxide magnetic particle powder in which the content of a nonmagnetic α-type iron-based oxide is reduced and the Fe sites of ε-Fe₂O₃ are partially substituted by another metal element, and a method for producing a substitution-type ε-iron oxide magnetic particle powder.

[Means for Solution] A substitution-type ε-iron oxide magnetic particle powder in which the content of an α-type iron-based oxide is reduced is obtained by neutralizing an acidic aqueous solution containing a trivalent iron ion and an ion of a metal that partially substitutes Fe sites to a pH of 2.0 or higher and 7.0 or lower, and thereafter adding a silicon compound having a hydrolyzable group to a dispersion liquid containing an iron oxyhydroxide having a substituent metal element or a mixture of an iron oxyhydroxide and a hydroxide of a substituent metal element formed, and subsequently neutralizing the dispersion liquid to a pH of 8.0 or higher and then performing aging by holding the dispersion liquid, and coating the iron oxyhydroxide having a substituent metal element or the mixture of the iron oxyhydroxide and the hydroxide of a substituent metal element with a chemical reaction product of the silicon compound, followed by heating.

## Description

### Technical Field

The present invention relates to a substitution-type ε-iron oxide magnetic particle powder suitable for a high-density magnetic recording medium, an electromagnetic wave absorber, etc., and particularly to a substitution-type ε-iron oxide magnetic particle powder in which the content of a non-magnetic α-type iron-based oxide that is a different phase from a substitution-type ε-iron oxide is reduced, and a method for producing the same. Note that in the present description, an oxide in which the Fe sites of ε-Fe₂O₃ are partially substituted by another metal element is sometimes referred to as "ε-type iron-based oxide", and a substitution-type α-iron oxide particle having the same crystal system as that of α-Fe₂O₃ is sometimes referred to as "a-type iron-based oxide".

### Background Art

While ε-Fe₂O₃ is an extremely rare phase among iron oxides, particles thereof having a nanometer order size show a great coercive force (Hc) of about 20 kOe (1.59 × 10⁶ A/m) at room temperature, and therefore, a production method for synthesizing ε-Fe₂O₃ as a single phase has been conventionally studied (PTL 1). However, when ε-Fe₂O₃ is used in a magnetic recording medium, there is currently no material for a magnetic head having a high-level saturation magnetic flux density corresponding thereto, and therefore, practically, it is necessary to adjust the coercive force by partially substituting the Fe sites of ε-Fe₂O₃ by a trivalent metal such as Al, Ga, or In, and even when it is used as an electromagnetic wave absorbing material, it is necessary to change the substitution amount for the Fe sites according to the absorption wavelength required (PTL 2).

On the other hand, since the magnetic particles of an ε-type iron-based oxide are extremely fine, in order to improve environmental stability and thermal stability, it has been studied that the Fe sites of ε-Fe₂O₃ are partially substituted by another metal having excellent heat resistance, and various types of partially substituted materials of ε-Fe₂O₃ having also excellent environmental stability and thermal stability represented by a general formula ε-AₓB_{y}Fe_{2-x-y}O₃ or ε-AₓB_{y}C_{z}Fe_{2-x-y-z}O₃ (wherein A is a divalent metal element such as Co, Ni, Mn, or Zn, B is a tetravalent metal element such as Ti, and C is a trivalent metal element such as In, Ga, or Al) have been proposed (PTL 3) .

ε-Fe₂O₃ and an ε-type iron-based oxide are each not a thermodynamically stable phase, and therefore, a special method is required for the production thereof. In the above-mentioned PTLs 1 to 3, a method for producing ε-Fe₂O₃ or an ε-type iron-based oxide, in which a fine crystal of an iron oxyhydroxide produced by a liquid-phase method or an iron oxyhydroxide having a substituent element is used as a precursor, and the precursor is coated with silicon oxide by a sol-gel method, followed by a heat treatment, is disclosed, and as the liquid-phase method, a reverse micelle method using an organic solvent as a reaction medium, and a method using only an aqueous solution as a reaction medium are disclosed, respectively.

Further, for example, in PTLs 4 to 5, the above-mentioned ε-Fe₂O₃ and ε-type iron-based oxide are shown to have an electromagnetic wave absorption peak in a high frequency range over 100 GHz, and are expected to be also used as an electromagnetic wave absorber.

However, a magnetic particle powder obtained by the production methods disclosed in PTLs 1 to 3 contains a non-magnetic α-type iron-based oxide as an impurity in a considerable amount other than the ε-Fe₂O₃ and the ε-type iron-based oxide.

In PTL 6, a technique for reducing the amount of an α-type iron-based oxide as an impurity contained in a substitution-type ε-iron oxide magnetic particle powder is disclosed.

In PTL 7, a method for producing an ε-type iron-based oxide including coating with silicon oxide by a sol-gel method in a wide pH range is disclosed.

### Citation List

### Patent Literature

PTL 1: JP-A-2008-174405
PTL 2: WO 2008/029861
PTL 3: WO 2008/149785
PTL 4: JP-A-2008-277726
PTL 5: JP-A-2009-224414
PTL 6: JP-A-2016-130208
PTL 7: JP-A-2018-092691

### Summary of Invention

### Technical Problem

An ε-type iron-based oxide, which is produced by the production method disclosed in the above-mentioned PTL 4, and in which the Fe sites are partially substituted, is configured such that the content of an α-type iron-based oxide as an impurity is reduced as compared with an ε-type iron-based oxide produced by a conventional method. However, the ε-type iron-based oxide is a semi-stable phase, and when the substitution amount of Fe by another metal element is small, even if the production method disclosed in PTL 4 is used, it becomes difficult to have the same space group as that of ε-Fe₂O₃, and the reduction of the content of the α-type iron-based oxide sometimes becomes insufficient.

The α-type iron-based oxide is non-magnetic, and therefore, when the substitution-type ε-iron oxide magnetic particle powder is used as an electromagnetic wave absorbing material, the α-type iron-based oxide does not contribute to the electromagnetic wave absorption characteristics, and also when the powder is used for a magnetic recording medium, the α-type iron-based oxide does not contribute to the enhancement of the recording density, and therefore, it is necessary to reduce the content thereof.

That is, a technical problem to be solved by the present invention is to provide a substitution-type ε-iron oxide magnetic particle powder in which the content of a non-magnetic α-type iron-based oxide is reduced, and a method for producing a substitution-type ε-iron oxide magnetic particle powder.

### Solution to Problem

The present inventors conducted intensive studies by paying attention to the fact that in order to obtain a substitution-type ε-iron oxide magnetic particle powder, it is necessary to heat a precursor of the magnetic particle powder in a state of being coated with silicon oxide, and as a result, they found that the content of an α-type iron-based oxide can be reduced by adding a silicon compound having a hydrolyzable group to be used for coating to an aqueous solution containing the precursor when the pH is 2.0 or higher and 7.0 or lower.

The present inventors completed the present invention described below based on the above finding.

In order to solve the above problem, in the present invention,
a substitution-type ε-iron oxide magnetic particle powder, mainly containing an ε-type iron-based oxide in which the Fe sites of ε-Fe₂O₃ are partially substituted by another metal element, wherein when the number of moles of Fe contained in the substitution-type ε-iron oxide magnetic particle powder is represented by Fe and the number of moles of all metal elements substituted for the Fe sites is represented by Me, the substitution amount of Fe by the another metal element defined by Me/(Fe+Me) is 0.08 or more and 0.17 or less, and the content of an α-type iron-based oxide measured by X-ray diffractometry is 3% or less is provided.

It is preferred that the another metal element that partially substitutes the Fe sites is Co, Ti, and one or more types selected from Ga and Al. For example, an ε-type iron-based oxide containing Co and Ti, and also containing one or more types selected from Ga and Al as the another metal element that partially substitutes the Fe sites can become a preferred target.

In the present invention, further, a green compact composed of the substitution-type ε-iron oxide magnetic particle powder is provided.

In the present invention, further, an electromagnetic wave absorber including the substitution-type ε-iron oxide magnetic particle powder dispersed in a resin or rubber is provided.

In the present invention, further, a method for producing a substitution-type ε-iron oxide magnetic particle powder mainly containing an ε-type iron-based oxide in which the Fe sites of ε-Fe₂O₃ are partially substituted by another metal element, the method including a neutralization step of obtaining a dispersion liquid containing an iron oxyhydroxide having a substituent metal element or a mixture of an iron oxyhydroxide and a hydroxide of a substituent metal element using an acidic aqueous solution containing a trivalent iron ion and an ion of a metal that partially substitutes the Fe sites as a raw material solution by adding an alkali to the raw material solution so as to neutralize the solution to a pH of 8.0 or higher and 10.0 or lower, a silicon compound addition step of adding a silicon compound having a hydrolyzable group to the dispersion liquid containing the iron oxyhydroxide having a substituent metal element or the mixture of the iron oxyhydroxide and the hydroxide of a substituent metal element, and an aging step of coating the iron oxyhydroxide having a substituent metal element or the mixture of the iron oxyhydroxide and the hydroxide of a substituent metal element with a chemical reaction product of the silicon compound by holding the dispersion liquid containing the iron oxyhydroxide having a substituent metal element or the mixture of the iron oxyhydroxide and the hydroxide of a substituent metal element, and the silicon compound at a pH of 8.0 or higher and 10.0 or lower, wherein the addition of the silicon compound having a hydrolyzable group is started when the pH of the dispersion liquid in the neutralization step is within a range of 2.0 or higher and 7.0 or lower, when the number of moles of the silicon compound to be added to the dispersion liquid with a pH of 2.0 or higher and 7.0 or lower is represented by S1, the number of moles of Fe ions contained in the raw material solution is represented by F, and the total number of moles of substituent metal element ions therein is represented by M, S1/(F+M) is 0.01 or more and 10.0 or less, and when the total number of moles of the silicon compound added is represented by S2, S2/(F+M) is 0.50 or more and 10.0 or less is provided.

In the production method, the addition of the alkali in the neutralization step and the addition of the silicon compound in the silicon compound addition step may both be performed continuously, or the addition of the alkali may be performed continuously and the addition of the silicon compound may be performed intermittently, or the addition of the alkali and the addition of the silicon compound may both be performed intermittently, or the addition of the alkali may be performed intermittently and the addition of the silicon compound may be performed continuously.

Further, in the production method, it is preferred that the another metal element that partially substitutes the Fe sites is Co, Ti, and one or more types selected from Ga and Al. For example, it is preferred that as the another metal element that partially substitutes the Fe sites, Co and Ti are contained, and also one or more types selected from Ga and Al are contained.

In the present invention, further, a method for producing a green compact, including compression-molding the substitution-type ε-iron oxide magnetic particle powder, thereby obtaining a green compact is provided.

### Advantageous Effects of Invention

By using the production method of the present invention, a substitution-type ε-iron oxide magnetic particle powder in which the content of an α-type iron-based oxide is reduced, and a green compact and an electromagnetic wave absorber using the same can be obtained.

### Brief Description of Drawings

[Fig. 1] Fig. 1 is a schematic view showing an example of an embodiment of the present invention.
[Fig. 2] Fig. 2 is a schematic view showing an example of an embodiment of the present invention.
[Fig. 3] Fig. 3 is a schematic view showing an example of an embodiment of the present invention.
[Fig. 4] Fig. 4 is a schematic view showing an example of an embodiment of the present invention.
[Fig. 5] Fig. 5 is a schematic view showing an example of an embodiment of the present invention.
[Fig. 6] Fig. 6 is a schematic view showing an example of an embodiment of the present invention.

### Description of Embodiments

### [Iron Oxide Magnetic Particle Powder]

The production method of the present invention is a method for producing a substitution-type ε-iron oxide magnetic particle powder mainly containing an ε-type iron-based oxide in which the Fe sites of ε-Fe₂O₃ are partially substituted by another metal element, and in the magnetic particle powder, a different phase that is an impurity unavoidable in the production is mixed. The different phase is mainly an α-type iron-based oxide, and an iron oxide magnetic particle powder obtained according to the present invention is substantially composed of ε-type iron-based oxide magnetic particles and an α-type iron-based oxide. An object of the present invention is to reduce the content of the α-type iron-based oxide that is a different phase.

Whether or not a partially substituted material in which the Fe sites of ε-Fe₂O₃ are partially substituted by another metal element has an ε-structure can be confirmed using X-ray diffractometry (XRD), high-energy electron diffractometry (HEED), or the like. In the present invention, the identification of ε-type and α-type iron-based oxides is performed by XRD.

Examples of the partially substituted material that can be produced by the production method of the present invention include the following.

One represented by a general formula: ε-C_{z}Fe_{2-z}O₃ (wherein C is one or more types of trivalent metal elements selected from In, Ga, and Al)

One represented by a general formula: ε-AₓB_{y}Fe_{2-x-y}O₃ (wherein A is one or more types of divalent metal elements selected from Co, Ni, Mn, and Zn, and B is one or more types of tetravalent metal elements selected from Ti and Sn)

One represented by a general formula: ε-AₓC_{z}Fe_{2-x-z}O₃ (wherein A is one or more types of divalent metal elements selected from Co, Ni, Mn, and Zn, and C is one or more types of trivalent metal elements selected from In, Ga, and Al)

One represented by a general formula: ε-AₓC_{y}Fe_{2-x-y}O₃ (wherein B is one or more types of tetravalent metal elements selected from Ti and Sn, and C is one or more types of trivalent metal elements selected from In, Ga, and Al)

One represented by a general formula: ε-AₓB_{y}C_{z}Fe_{2-x-y-z}O₃ (wherein A is one or more types of divalent metal elements selected from Co, Ni, Mn, and Zn, B is one or more types of tetravalent metal elements selected from Ti and Sn, and C is one or more types of trivalent metal elements selected from In, Ga, and Al)

Here, the material of the type substituted only by the element C has an advantage that the coercive force of magnetic particles can be arbitrarily controlled, and also the same space group as that of ε-Fe₂O₃ is easy to obtain, however, the thermal stability may sometimes be poor. In particular, when Ga and Al are used as C, the obtained substitution-type ε-iron oxide magnetic particle powder has slightly poor thermal stability, and therefore, it is preferred that the material is further substituted by the element A and/or B simultaneously. The material of the type substituted by three elements A, B, and C is best balanced among the above-mentioned characteristics, and is excellent in heat resistance, ease of acquisition of a single phase, and controllability of the coercive force. When Ga and Al are used as C, the material is preferably substituted also by Co and Ti simultaneously.

Note that the production method of the present invention can also be applied to the substitution-type iron oxide magnetic particles of any of the substitution types described above.

The production method of the present invention described below can be applied whatever value the substitution amount of the metal element that substitutes the Fe site is, however, the application is effective in the substitution amount in which an α-type iron-based oxide is easy to form. Specifically, in the case where the production method is applied when the number of moles of Fe contained in the substitution-type ε-iron oxide magnetic particle powder is represented by Fe and the number of moles of all metal elements substituted for the Fe sites is represented by Me, and the substitution amount of Fe by the another metal element defined by Me/(Fe+Me) is 0.08 or more and 0.17 or less, a substitution-type ε-iron oxide magnetic particle powder having an α-type iron-based oxide content measured by XRD of 3% or less, which could not be obtained by a conventional method, can be obtained.

### [Green Compact and Electromagnetic Wave Absorber]

The substitution-type ε-iron oxide magnetic particle powder obtained according to the present invention functions as an electromagnetic wave absorber having an excellent electromagnetic wave absorption ability by forming a packed structure of the powder particles thereof. The "packed structure" as used herein means a structure in which respective particles constitute a three-dimensional structure in a state where the particles are in contact with each other or in close proximity to each other. In order to put the powder to practical use in the electromagnetic wave absorber, it is necessary to maintain the packed structure. As a method therefor, for example, a method in which the substitution-type ε-iron oxide magnetic particle powder is formed into a green compact by compression molding, or a method in which the packed structure is formed by adhering the substitution-type ε-iron oxide magnetic particle powder using a non-magnetic polymer compound as a binder is exemplified.

In the case of the method using a binder, the substitution-type ε-iron oxide magnetic particle powder is mixed with a non-magnetic polymer base material, thereby obtaining a kneaded material. The blending amount of the electromagnetic wave absorbing material powder in the kneaded material is preferably set to 60 mass% or more. As the blending amount of the electromagnetic wave absorbing material powder is larger, it is more advantageous to the improvement of the electromagnetic wave absorption characteristics. However, if the blending amount is too large, it becomes difficult to knead it with the polymer base material, and therefore, attention should be paid. For example, the blending amount of the electromagnetic wave absorbing material powder can be set to 80 to 95 mass%, or 85 to 95 mass%.

As the polymer base material, various types of materials that satisfy heat resistance, flame retardancy, durability, mechanical strength, and electrical characteristics can be used according to the usage environment. For example, an appropriate material may be selected from a resin (nylon or the like), a gel (a silicone gel or the like), a thermoplastic elastomer, rubber, and the like. Further, two or more types of polymer compounds may be blended and used as the base material.

### [Average Particle Diameter]

In the present invention, the average particle diameter of the iron oxide magnetic particle powder obtained by the production method of the present invention is not particularly specified, but it is preferred that each particle is fine enough to have a single magnetic domain structure. In general, one having an average particle diameter measured by a transmission electron microscope of 10 nm or more and 40 nm or less is obtained.

### [Starting Material and Precursor]

In the production method of the present invention, an acidic aqueous solution containing a trivalent iron ion and a metal ion of a metal element that finally substitutes an Fe site as starting materials of the iron-based oxide magnetic particle powder (hereinafter referred to as "raw material solution") is used. If a divalent Fe ion is used in place of the trivalent Fe ion as the starting material, a mixture containing a hydrate oxide of divalent iron, a magnetite, or the like other than a hydrate oxide of trivalent iron is formed as a precipitate, and a variation in the shape of the iron-based oxide particles to be obtained finally occurs, and therefore, a substitution-type ε-iron oxide magnetic particle powder in which the content of an α-type iron-based oxide is reduced as in the present invention cannot be obtained. Here, the "acidic" means that the pH of the liquid is lower than 7.0. As the supply source of the iron ion or the metal ion of a substituent element, a watersoluble inorganic acid salt such as a nitrate, a sulfate, or a chloride is preferably used from the viewpoint of ease of availability and price. When such a metal salt is dissolved in water, the metal ion dissociates, and the aqueous solution exhibits acidity. When an alkali is added to the acidic aqueous solution containing the metal ion to neutralize the solution, a precipitate of a mixture of an iron oxyhydroxide and a hydroxide of a substituent element, or an iron oxyhydroxide in which the Fe sites are partially substituted by another metal element (in the present description, hereinafter these are collectively referred to as "iron oxyhydroxide having a substituent element") is obtained. In the production method of the present invention, such an iron oxyhydroxide having a substituent element is used as a precursor of the substitution-type ε-iron oxide magnetic particle powder.

The total metal ion concentration in the raw material solution is not particularly specified in the present invention, but is preferably 0.01 mol/L or more and 0.5 mol/L or less. When the total metal ion concentration is less than 0.01 mol/L, the amount of the substitution-type ε-iron oxide magnetic particle powder obtained by a single reaction is small, and therefore, such a concentration is not preferred from the economic viewpoint. When the total metal ion concentration exceeds 0.5 mol/L, the reaction solution tends to be gelled due to rapid formation of a precipitate of a hydroxide, and therefore, such a concentration is not preferred.

### [Neutralization Step]

In the production method of the present invention, an alkali is added to the raw material solution to neutralize the solution until the pH has reached 8.0 or higher and 10.0 or lower, thereby obtaining a dispersion liquid containing a precipitate of the iron oxyhydroxide having a substituent element. Note that the hydroxide of a trivalent iron ion is mainly composed of an oxyhydroxide. The reason why the pH of the dispersion liquid is set to 8.0 or higher here is to complete the formation of a precipitate of a hydroxide of a substituent metal element, for example, Co, and to promote a condensation reaction of a silanol derivative that is a hydrolysate. In the production method of the present invention, the upper limit of the pH to be reached in the neutralization step is not particularly specified, but the effect of neutralization becomes saturated, and the effect of promoting the below-mentioned condensation reaction of a silanol derivative is lowered, and therefore, the upper limit is preferably set to 10.0.

The alkali used for neutralization may be any of a hydroxide of an alkali metal or an alkaline earth metal, aqueous ammonia, and an ammonium salt such as ammonium hydrogen carbonate, but it is preferred to use aqueous ammonia or ammonium hydrogen carbonate which is less likely to leave impurities when the ε-type iron-based oxide is formed by a heat treatment in the end. Such an alkali may be added in the form of a solid to the aqueous solution of the starting material, but is preferably added in a state of an aqueous solution from the viewpoint of ensuring the uniformity of the reaction.

As described above, when the neutralization treatment is performed by adding the alkali to the raw material solution, a precipitate of the iron oxyhydroxide having a substituent element is precipitated, and therefore, it is preferred to stir the dispersion liquid containing the precipitate during the neutralization treatment by a known mechanical means.

The addition of the alkali to the raw material solution may be performed continuously from the start to completion of the addition. Further, before the pH of the dispersion liquid has reached 8.0, the addition of the alkali is discontinued and a predetermined pH holding time may be provided. In that case, the addition of the alkali can be performed intermittently by providing the pH holding time multiple times. Note that the number of times that the pH holding time is provided, that is, the number of times that the addition of the alkali is discontinued is preferably set to three times or less so as to prevent the production process from becoming complicated.

In the production method of the present invention, the reaction temperature during the neutralization treatment is set to 5°C or higher and 60°C or lower. When the reaction temperature is lower than 5°C, the cost of cooling increases, and therefore, such a temperature is not preferred. When the reaction temperature exceeds 60°C, an α-type oxide that is a different phase tends to be formed in the end, and therefore, such a temperature is not preferred. The reaction temperature is more preferably 10°C or higher and 40°C or lower. In the case of the above-mentioned production method described in PTL 4, it is necessary to perform the neutralization treatment at 5°C or higher and 25°C or lower, so that it is necessary to use a freezer during the reaction, however, in the production method of the present invention, it is also possible to perform the neutralization treatment at a reaction temperature not lower than normal temperature.

Note that the value of pH described in the present description was measured using a glass electrode according to JIS Z 8802. It refers to a value measured with a pH meter calibrated using a suitable buffer solution corresponding to the pH range to be measured as a pH standard solution. Further, the pH described in the present description is a value obtained by directly reading a measured value shown by a pH meter compensated with a temperature compensation electrode under the reaction temperature conditions.

### [Silicon Compound Addition Step]

In the production method of the present invention, the iron oxyhydroxide having a substituent element that is the precursor of the substitution-type ε-iron oxide magnetic particle powder formed in the above step hardly undergoes phase transition to the ε-type iron-based oxide even if it is subjected to a heat treatment as it is, and therefore, it is necessary to coat the iron oxyhydroxide having a substituent element with a chemical reaction product obtained by a hydrolysis reaction and a condensation reaction of a silicon compound prior to the heat treatment. Note that the chemical reaction product of the silicon compound here is used as a general term of not only silicon oxide having a stoichiometric composition, but also one having a nonstoichiometric composition such as the below-mentioned silanol derivative or a polysiloxane structure, and also one converted to silicon oxide by being subjected to a heating treatment, and the like.

In the production methods described in PTLs 1 to 4, as a coating method of the silicon compound with the chemical reaction product, a sol-gel method is used, and the silicon compound having a hydrolyzable group is added to the reaction solution after the neutralization treatment of the raw material solution is completed and the pH of the reaction solution is changed to the alkaline side. On the other hand, in the production method of the present invention, although a sol-gel method is used in the same manner as the coating method with silicon oxide, the method is characterized in that the addition of the silicon compound having a hydrolyzable group is started when the pH of the reaction solution is in a range of 2.0 or higher and 7.0 or lower that is on the acidic side before the neutralization of the raw material solution is completed. Note that the completion time of the addition of the silicon compound will be described later.

In the case of the sol-gel method, to the dispersion liquid containing the iron oxyhydroxide having a substituent element, a silicon compound having a hydrolyzable group, for example, an alkoxysilane such as tetraethoxysilane (TEOS) or tetramethoxysilane (TMOS), or a silane compound such as any of various types of silane coupling agents is added to cause a hydrolysis reaction under stirring, and the resulting silanol derivative is condensed to form a polysiloxane bond, thereby coating the surface of the iron oxyhydroxide having a substituent element.

The present inventors found that when the addition of the silicon compound having a hydrolyzable group is started at a pH of 2.0 or higher and 7.0 or lower, the content of an α-type iron-based oxide contained in the substitution-type ε-iron oxide magnetic particle powder obtained finally can be reduced, and the reason therefor is considered as follows.

The rate of the hydrolysis reaction of the silicon compound having a hydrolyzable group and the rate of the condensation reaction of the silanol derivative that is a hydrolysate change depending on the pH of the reaction system. The hydrolysis reaction rate is generally high in a low pH range on the acidic side, and decreases with an increase in pH, and increases again in a high pH range on the alkaline side. On the other hand, the condensation reaction rate is low in a low pH range on the acidic side, and increases with an increase in pH, and becomes higher in a pH range on the alkaline side from the neutral pH.

When the silicon compound having a hydrolyzable group is added in a low pH range on the acidic side to the dispersion liquid containing a precipitate of the iron oxyhydroxide having a substituent element, the hydrolysis of the silicon compound rapidly proceeds, and a silanol derivative that does not contain much organic components is formed, but on the other hand, the condensation reaction of the formed silanol derivative does not proceed. Here, the silanol derivative has an OH group that is a hydrophilic group, and is uniformly distributed in the aqueous solution, and therefore, it is considered that the precipitate of the iron oxyhydroxide having a substituent element and the silanol derivative are uniformly dispersed in the dispersion liquid, and become in a coexisting state.

Thereafter, when the pH of the dispersion liquid is further increased, the condensation reaction of the silanol derivative becomes dominant, and therefore, the precipitate of the iron oxyhydroxide having a substituent element is uniformly coated with the silanol derivative or the condensation reaction product thereof. Therefore, it is considered that the content of an α-type iron-based oxide contained in the substitution-type ε-iron oxide magnetic particle powder obtained finally by performing the heat treatment is reduced.

Note that in PTL 5 described above, it is disclosed that silicon oxide coating is performed by a sol-gel method in a wide pH range, however, in that case, the addition of the silicon compound is performed at a constant pH after completion of the neutralization treatment, and a technical idea that both the hydrolysis reaction rate and the condensation reaction rate of the silicon compound are considered as in the present invention is not disclosed.

The pH at which the addition of the silicon compound having a hydrolyzable group is started is preferably 2.0 or higher. When the pH is lower than 2.0, the formation of the precipitate of the hydroxide of the trivalent iron ion contained in the raw material solution, which is the main component of the substitution-type ε-iron oxide magnetic particle powder, may be insufficient. The pH at which the addition is started is more preferably 3.0 or higher. Further, the pH at which the addition of the silicon compound having a hydrolyzable group is started is preferably 7.0 or lower. When the pH exceeds 7.0, the hydrolysis reaction becomes slow, and the formation of the silanol derivative becomes insufficient, and therefore, a state where the precipitate of the iron oxyhydroxide having a substituent element and the silanol derivative are uniformly dispersed and coexist in the dispersion liquid cannot be obtained, and it becomes difficult to uniformly coat the precipitate of the iron oxyhydroxide having a substituent element with the silanol derivative or the condensation reaction product thereof. The pH at which the addition is started is preferably 6.0 or lower, and more preferably 4.0 or lower.

The addition of the silicon compound having a hydrolyzable group is started when the pH of the raw material solution becomes a desired value in the neutralization step. The addition of the silicon compound may be performed continuously from the start to completion of the addition. The "continuously" as used herein includes adding the total amount of the silicon compound to be added to the dispersion liquid at a time to the dispersion liquid. Further, the addition of the silicon compound may be divided into multiple times and performed intermittently.

In the production method of the present invention, the amount of the silicon compound to be added to the dispersion liquid needs to simultaneously satisfy the following two conditions.

A first condition is the amount of the silicon compound to be added to the dispersion liquid with a pH of 2.0 or higher and 7.0 or lower. When the number of moles of the silicon compound to be added to the dispersion liquid with a pH of 2.0 or higher and 7.0 or lower is represented by S1, the number of moles of Fe ions contained in the raw material solution is represented by F, and the total number of moles of substituent metal element ions therein is represented by M, S1/(F+M) is set to 0.01 or more and 10.0 or less. When the S1/(F+M) is less than 0.01, the amount of the silanol derivative that coexists with the precipitate of the iron oxyhydroxide having a substituent element is small, and an effect of uniformly coating the precipitate of the iron oxyhydroxide having a substituent element with the silanol derivative or a condensation reaction product thereof is lowered, and therefore, such a ratio is not preferred. When the addition amount of the silicon compound is increased, the treatment amount in the below-mentioned heating step and silicon oxide removal step increases to increase the production cost, and therefore, the S1/(F+M) is preferably 10.0 or less.

A second condition is the amount of the silicon compound to be added in the whole production process. When the total number of moles of the silicon compound to be added is represented by S2, the number of moles of Fe ions contained in the raw material solution is represented by F, and the total number of moles of substituent metal element ions therein is represented by M, S2/(F+M) is set to 0.50 or more and 10.0 or less. When the S2/(F+M) is less than 0.50, the coating amount of the chemical reaction product of the silicon compound to be coated on the surface of the precipitate of the iron oxyhydroxide having a substituent element becomes small, and as a result, there is a disadvantage that an α-type iron-based oxide tends to be formed, and therefore, such a ratio is not preferred. Further, when the S2/(F+M) exceeds 10.0, the treatment amount in the below-mentioned heating step and silicon oxide removal step increases to increase the production cost, and therefore, such a ratio is not preferred.

Note that when the total amount of the silicon compound is added within a pH range of 2.0 or higher and 7.0 or lower, S1=S2.

### [Embodiments of Present Invention]

As described above, in the production method of the present invention, the addition of the alkali in the neutralization step and the addition of the silicon compound in the silicon compound addition step each can be performed continuously or intermittently. Therefore, the production method of the present invention can have various embodiments by combining the method of adding the alkali and the method of adding the silicon compound. Hereinafter, several embodiments of the present invention will be illustrated, however, the production method of the present invention is not limited to the embodiments described below.

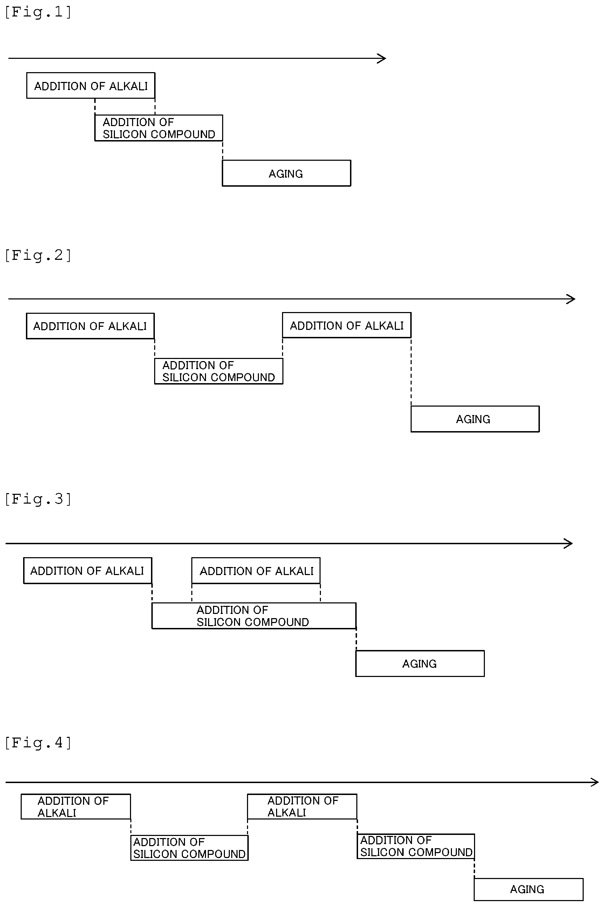

In Fig. 1, a time course of an embodiment in which the addition of the alkali and the addition of the silicon compound are both performed continuously is schematically illustrated. In that case, after the addition of the alkali is started, when the pH of the raw material solution has reached a given pH within a range of 2.0 or higher and 7.0 or lower, the addition of the silicon compound is started. In the case of this embodiment, the neutralization step and the silicon compound addition step are not temporally continuous steps, but are parallel steps. As shown in this drawing, the addition of the silicon compound may be continued after the addition of the alkali is completed, or may be completed when the addition of the alkali is completed or when the pH is 7.0 or lower. When the addition of the silicon compound is performed even after the addition of the alkali is completed, it is preferred to complete the addition of the silicon compound within 120 minutes after the addition of the alkali is completed in consideration of the time of the whole production process. After the addition of the silicon compound is completed, the below-mentioned aging step is provided.

Note that although not particularly illustrated, in the embodiment in Fig. 1, the addition of the silicon compound may be divided into several times and performed intermittently.

In Fig. 2, a time course of one example of an embodiment in which the addition of the alkali is discontinued in the middle of the neutralization step is schematically illustrated. In that case, the discontinuation of the addition of the alkali is performed once, and the total amount of the silicon compound is continuously added within the pH holding time during which the addition of the alkali is discontinued, and S1=S2.

In Fig. 3, a time course of another example of an embodiment in which the discontinuation of the addition of the alkali is performed once is schematically illustrated. In that case, the addition of the silicon compound is started when the pH of the raw material solution has reached a given pH within a range of 2.0 or higher and 7.0 or lower, however, the completion time point of the addition is after completion of the neutralization step, and the form of the addition of the silicon compound is continuous.

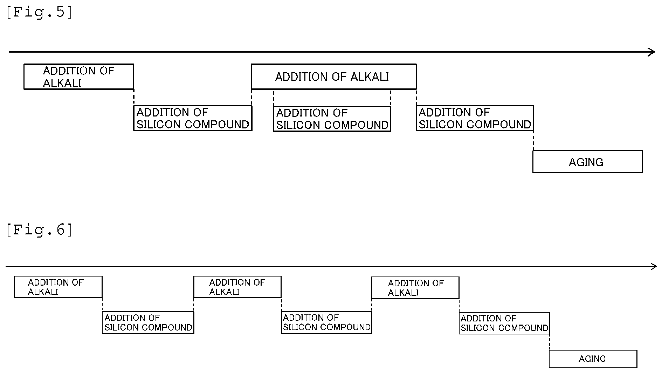

In each of Figs. 4 and 5, a time course of an example of an embodiment in which the discontinuation of the addition of the alkali is performed once and the addition of the silicon compound is performed intermittently is schematically illustrated. The addition of the silicon compound is performed by being divided into twice in Fig. 4 and divided into three times in Fig. 5.

In Fig. 6, a time course of an example of an embodiment in which the discontinuation of the addition of the alkali is performed twice and the addition of the silicon compound is performed intermittently three times is schematically illustrated.

Note that as described above, the production method of the present invention is not limited to the embodiments illustrated in Figs. 1 to 6, and the form of the addition of the alkali in the neutralization step and the form of the addition of the silicon compound in the silicon compound addition step can be arbitrarily combined.

### [Aging Step]

Even when the pH is set to 8.0 or higher, the condensation reaction of the silanol derivative slowly proceeds, and therefore, the dispersion liquid containing the iron oxyhydroxide having a substituent element and the chemical reaction product of the silicon compound obtained through the neutralization step and the silicon compound addition step is aged by holding the dispersion liquid at a pH of 8.0 or higher so as to allow the condensation reaction of the silanol derivative to proceed. As a result, a uniform coating layer of the condensation reaction product of the silanol derivative is formed on the surface of the precipitate of the iron oxyhydroxide having a substituent element. It is considered that the coating layer coats substantially the entire surface of the precipitate of the iron oxyhydroxide having a substituent element, however, the existence of an uncoated portion on the surface of the precipitate of the iron oxyhydroxide having a substituent element is permitted as long as the effect of the present invention can be achieved. The aging time is preferably 1 hour or more and 24 hours or less. When the holding time is less than 1 hour, coating of the precipitate of the iron oxyhydroxide having a substituent element by condensation of the silanol derivative is not completed, and an α-type iron-based oxide tends to be formed, and when the holding time exceeds 24 hours, the aging effect is saturated, and therefore, such a holding time is not preferred. Note that the aging time is a time after completion of the addition of the silicon compound when the addition of the silicon compound is continued even after completion of the neutralization step, and a time after completion of the addition of the alkali when the addition of the silicon compound is completed before completion of the neutralization step.

In the method for producing a substitution-type ε-iron oxide magnetic particle powder of the present invention, as a step after the aging step, for example, the same step as in a conventional production method described in PTLs 1 to 4 can be used. Specifically, a step as described below is exemplified.

### [Heating Step]

In the production method of the present invention, the iron oxyhydroxide having a substituent element coated with the condensation reaction product of the silanol derivative is recovered using a known solid-liquid separation method, and then subjected to a heating treatment, whereby an ε-type iron-based oxide is obtained. Prior to the heating treatment, washing and drying steps may be provided. The heating treatment is performed in an oxidative atmosphere, and the oxidative atmosphere may be an air atmosphere. The heating can be generally performed within a range of 700°C or higher and 1300°C or lower, however, when the heating temperature is high, α-Fe₂O₃ that is a thermodynamically stable phase (which is an impurity of ε-Fe₂O₃) tends to be formed, and therefore, the heating treatment is performed preferably at 900°C or higher and 1200°C or lower, and more preferably at 950°C or higher and 1150°C or lower.

The heat treatment time can be adjusted within a range of about 0.5 hours or more and 10 hours or less, but favorable results are likely to be obtained within a range of 2 hours or more and 5 hours or less. Note that it is considered that the existence of the silicon-containing substance that coats the particles acts advantageously not for causing phase transition to the α-type iron-based oxide, but for causing phase transition to the ε-type iron-based oxide. Further, the silicon oxide coating has an effect of preventing sintering of crystals of the iron oxyhydroxide having a substituent element during the heating treatment.

When the ε-type iron-based oxide magnetic particle powder does not need coating with silicon oxide, the silicon oxide coating may be removed after the heating treatment.

### [Compositional Analysis by High-Frequency Inductively Coupled Plasma Atomic Emission Spectroscopy (ICP)]

The compositional analysis of the obtained substitution-type ε-iron oxide magnetic particle powder was performed by a dissolution method. In the compositional analysis, ICP-720ES manufactured by Agilent Technologies, Inc. was used, and the analysis was performed by setting the measurement wavelength (nm) as follows: Fe: 259.940 nm, Ga: 294.363 nm, Co: 230.786 nm, Ti: 336.122 nm, and Si: 288.158 nm.

### [Measurement of Magnetic Hysteresis Curve (Bulk B-H Curve)]

By using a vibrating sample magnetometer VSM (VSM-P7, manufactured by Toei Industry Co., Ltd.), magnetic characteristics were measured at an applied magnetic field of 1193 kA/m (15 kOe), an M measurement range of 0.005 A·m² (5 emu), a step bit of 140 bit, a time constant of 0.03 sec, and a wait time of 0.1 sec. The coercive force Hc and the saturation magnetization σs were evaluated based on a B-H curve.

### [Evaluation of Crystallinity by X-ray Diffractometry (XRD)]

The obtained samples were subjected to powder X-ray diffraction (XRD: sample horizontal-type multipurpose X-ray diffractometer Ultima IV, manufactured by Rigaku Corporation, radiation source: CuKα, voltage: 40 kV, current: 40 mA, 2θ = 10° or more and 70° or less). The obtained diffraction pattern was evaluated by a Rietveld analysis using integrated powder X-ray analysis software (PDXL2, manufactured by Rigaku Corporation) based on ICSD (Inorganic Crystal Structure Database) No. 173025: Iron(III) Oxide-Epsilon, No. 82134: Hematite, and the crystal structure and the content of an α-phase were confirmed.

### [BET Specific Surface Area]

The BET specific surface area was determined by a BET single point method using Macsorb Model-1210 manufactured by Mountech Co., Ltd.

TEM observation of the substitution-type ε-iron oxide magnetic particle powder obtained by the production method of the present invention was performed under the following conditions. In the TEM observation, JEM-1011 manufactured by JEOL, Ltd. was used. For particle observation, TEM images captured at a magnification of 10,000 times and 100,000 times were used (those after removing the silicon oxide coating were used).

### -Measurement of Average Particle Diameter and Particle Size Distribution Evaluation (Coefficient of Variation (%))-

Digitization was used for TEM average particle diameter and particle size distribution evaluation (coefficient of variation (%)). As image processing software, Mac-View Ver. 4.0 was used. When the image software is used, the particle diameter of a certain particle is calculated as the length of the long side of a rectangle having the smallest area among the rectangles circumscribing the particle. As for the number of particles, 200 or more particles were measured.

Among the particles on the transmission electron micrograph, the selection criteria for a particle to be measured were as follows.
[1] A particle that is partially outside the visual field of the micrograph is not measured.
[2] A particle with a well-defined contour and existing independently is measured.
[3] Even if the particle shape deviates from the average particle shape, a particle that is independent and can be measured as a single particle is measured.
[4] Particles that overlap each other, but the boundaries between the particles are clear, and also the shape of the entire particle can be determined are each measured as a single particle.
[5] Overlapping particles whose boundaries are not clear and also whose overall shape is unknown are not measured as particles whose shape cannot be determined.

The number average particle diameter of the particles selected based on the above criteria was calculated and used as the average particle diameter by TEM observation of the substitution-type ε-iron oxide magnetic particle powder.

### [Measurement of Electromagnetic Wave Absorption Characteristics]

1.2 g of the substitution-type ε-iron oxide powder was compression-molded at 28 MPa (20 kN), thereby obtaining a green compact having a diameter of 13 mm and a thickness of 3 mm. For the obtained green compact, transmission attenuation measurement was performed by terahertz wave time-domain spectroscopy. Specifically, measurement was performed in the case where the green compact was placed in a sample holder and in the case of blank using a terahertz spectroscopic system TAS7400SL manufactured by Advantest Co., Ltd. The measurement conditions were set as follows.
- Sample holder diameter: φ 10 mm
- Measurement Mode: Transmission
- Frequency Resolution: 1.9 GHz
- Vertical Axis: Absorbance
- Horizontal Axis: Frequency [THz]
- Cumulated Number (Sample): 2048
- Cumulated Number (Background): 2048

The observed signal waveform of the sample and the reference waveform of the blank were expanded to 2112 ps and Fourier-transformed, and the ratio (Ssig/Sref) of the obtained Fourier spectra (denoted by Sref and Ssig, respectively) was determined, and the transmission attenuation of the green compact placed in the sample holder was calculated.

### Examples

### [Example 1]

In a 5 L reaction vessel, 283.26 g of ferric(III) nitrate nonahydrate with a purity of 99%, 56.36 g of a Ga(III) nitrate solution having a Ga concentration of 11.55 mass%, 6.25 g of cobalt (II) nitrate hexahydrate with a purity of 97%, and 6.61 g of titanium(IV) sulfate having a Ti concentration of 15.1 mass% were dissolved in 3,813.21 g of pure water while mechanically stirring with a stirring blade in the air atmosphere, thereby forming a raw material solution (procedure 1). The pH of the raw material solution was about 1. The molar ratio of metal ions in the raw material solution is as follows: Fe:Ga:Co:Ti = 1.677:0.223:0.050:0.050. Note that the Roman numeral in parentheses following the reagent name denotes the valence of the metal element.

While mechanically stirring the raw material solution with a stirring blade under the condition of 20°C in the air atmosphere, 294.85 g of a 22.30 mass% ammonia aqueous solution was added thereto over 90 minutes (procedure 2).

After 60 minutes, when the pH of the reaction solution during addition of the ammonia aqueous solution reached 4.0, the addition of 519.22 g of tetraethoxysilane (TEOS) with a purity of 95.0 mass% as the silicon compound having a hydrolyzable group was started in parallel, and it was added dropwise over 30 minutes. After all the ammonia aqueous solution was added, stirring was continued as such for 20 hours, thereby coating the precipitate of the iron oxyhydroxide having a substituent element with the chemical reaction product of the silicon compound (procedure 3). The pH of the reaction solution at the completion of the addition of the ammonia aqueous solution and the pH of the reaction solution throughout the period when stirring was performed for 20 hours were both 8.8. Note that under the conditions, the molar ratio of the amount of Si element contained in tetraethoxysilane added to the dispersion liquid with a pH of 2.0 or higher and 7.0 or lower to the amount of iron, gallium, cobalt, and titanium ions contained in the raw material solution, S1/(F+M), is 0.34, and the molar ratio of the total amount of Si element contained in tetraethoxysilane added dropwise to the dispersion liquid to the amount of iron, gallium, cobalt, and titanium ions contained in the raw material solution, S2/(F+M), is 2.84.

The slurry obtained by the procedure 3 was filtered, and after water in the obtained precipitate of the iron oxyhydroxide having a substituent element coated with the chemical reaction product of the silicon compound was drained off as much as possible, the precipitate was redispersed in pure water and repulp washing was performed. The slurry after washing was filtered again, and the resulting cake was dried at 110°C in the air (procedure 4).

The dried product obtained by the procedure 4 was subjected to a heating treatment for 4 hours at 1090°C in the air using a box-type firing furnace, whereby an iron-based oxide magnetic powder coated with silicon oxide was obtained (procedure 5). Note that the chemical reaction product of the silicon compound is converted to an oxide by dehydration when the heat treatment is performed in the air atmosphere.

The production conditions such as the preparation conditions for the raw material solution of this Example are shown in Table 1. In Table 1, the production conditions of the other Examples and Comparative Examples are also shown.

The heat-treated powder resulting from the heat treatment of the precipitate of the iron oxyhydroxide having a substituent element coated with the chemical reaction product of the silicon compound obtained by the procedure 5 was stirred at about 60°C for 24 hours in a 17.58 mass% NaOH aqueous solution to perform a treatment of removing the silicon oxide coating on the surfaces of the particles (procedure 6). Subsequently, washing was performed using a centrifuge until the electrical conductivity of the slurry reached 500 mS/m or less, followed by filtering through a membrane filter and drying, and the resulting iron-based oxide magnetic powder was subjected to a chemical analysis of the composition thereof, XRD measurement, magnetic characteristic measurement, and the like. The measurement results are shown in Table 2. In Table 2, the physical property values of the substitution-type ε-iron oxide magnetic particle powders obtained in the other Examples and Comparative Examples are also shown.

When XRD measurement was performed for the substitution-type ε-iron oxide magnetic particle powder according to the Example 1 and the content of an α-phase was determined, it was 1.3%. This value is superior to that of the below-mentioned substitution-type ε-iron oxide powder obtained in Comparative Example 1 in which an intermediate aging step was provided after the pH reached 8.9 after adding the ammonia solution, and thereafter, TEOS was added in a state where the pH was 8.9. Further, the chemical analysis of the composition and the evaluation of the magnetic characteristics were performed. The measurement results are also shown in Table 2.

### [Example 2]

As Example 2, a substitution-type ε-iron oxide magnetic particle powder was obtained by the same procedure as in Example 1 except that the temperature when the ammonia aqueous solution was added was set to 30°C, the addition time of the ammonia aqueous solution was set to 30 minutes, the pH at which the addition of TEOS was started was set to 6.0, the addition rate of TEOS was set to 5.88 g/min during the addition of the ammonia aqueous solution and 22.47 g/min after completion of the ammonia aqueous solution. Note that the pH at the completion of the addition of the ammonia aqueous solution was 8.9, and the pH of the reaction solution at the completion of the addition of TEOS and the pH of the reaction solution throughout the period when stirring was performed for 20 hours were both 8.8. When XRD measurement was performed for the substitution-type ε-iron oxide magnetic particle powder according to the Example 2 and the content of an α-phase was determined, it was 3.0%. This value is superior to that of the below-mentioned substitution-type ε-iron oxide magnetic particle powder obtained in Comparative Example 3 in which an aging step was provided for 30 minutes after the pH reached 8.9 after adding the ammonia solution, and thereafter, TEOS was added in a state where the pH was 8.9. Further, the chemical analysis of the composition and the evaluation of the magnetic characteristics were performed. The measurement results are also shown in Table 2.

### [Comparative Example 1]

As Comparative Example 1, a substitution-type ε-iron oxide magnetic particle powder was obtained by the same procedure as in Example 1 except that TEOS was added when the pH reached 8.9 by adding the ammonia aqueous solution, and thereafter, the aging step was provided. Note that the pH at the completion of the addition of ammonia was 8.9, and the pH of the reaction solution at the completion of the addition of TEOS and the pH of the reaction solution throughout the period when stirring was performed for 20 hours were both 8.8. When XRD measurement was performed for the substitution-type ε-iron oxide magnetic particle powder according to the Comparative Example 1 and the content of an α-phase was determined, it was 3.6%, which was a higher value than those of Examples 1 to 6. Further, the chemical analysis of the composition and the evaluation of the magnetic characteristics were performed. The measurement results are also shown in Table 2.

### [Comparative Example 2]

As Comparative Example 2, a substitution-type ε-iron oxide magnetic particle powder was obtained by the same procedure as in Example 1 except that the temperature when the ammonia aqueous solution was added was set to 25°C, the addition time of the ammonia aqueous solution was set to 60 minutes, an intermediate aging step was provided for 30 minutes after the pH of the dispersion liquid reached 8.9 after adding the ammonia aqueous solution, and thereafter, TEOS was added in a state where the pH was 8.9. Note that the pH of the reaction solution at the completion of the addition of TEOS and the pH of the reaction solution during the stirring for 20 hours were both 8.8. When XRD measurement was performed for the substitution-type ε-iron oxide magnetic particle powder according to the Comparative Example 2 and the content of an α-phase was determined, it was 7.4%, which was a higher value than those of Examples 1 to 6. Further, the chemical analysis of the composition and the evaluation of the magnetic characteristics were performed. The measurement results are also shown in Table 2.

### [Comparative Example 3]

As Comparative Example 3, a substitution-type ε-iron oxide magnetic particle powder was obtained by the same procedure as in Example 2 except that the aging step was provided after the pH reached 8.9 by adding the ammonia aqueous solution, and thereafter, TEOS was added in a state where the pH was 8.9. Note that the pH of the reaction solution at the completion of the addition of TEOS and the pH of the reaction solution during the stirring for 20 hours were both 8.8. When XRD measurement was performed for the substitution-type ε-iron oxide magnetic particle powder according to the Comparative Example 3 and the content of an α-phase was determined, it was 5.4%, which was a higher value than those of Examples 1 to 6. Further, the chemical analysis of the composition and the evaluation of the magnetic characteristics were performed. The measurement results are also shown in Table 2.

From the above results, in the case where the neutralization treatment was performed continuously, the effect of setting the TEOS addition start time to when the pH is 2.0 or higher and 7.0 or lower is apparent. Further, as shown by the results of Example 2, in the case of the production method of the present invention, even if the neutralization treatment is performed at 30°C that is higher than normal temperature, a substitution-type ε-iron oxide magnetic particle powder having a low α-phase content is obtained.

### [Example 3]

As Example 3, a substitution-type ε-iron oxide magnetic particle powder was obtained by the same procedure as in Example 1 except that the addition of the ammonia aqueous solution was stopped after adding the ammonia aqueous solution until the pH reached 4.0 (first neutralization step), and immediately the addition of TEOS was started without providing an intermediate aging step, and after completion of the addition of TEOS, the rest of the ammonia aqueous solution was added (second neutralization step). Note that the pH of the reaction solution at the completion of the second neutralization step and the pH of the reaction solution during the stirring for 20 hours were both 8.8. When XRD measurement was performed for the substitution-type ε-iron oxide magnetic particle powder according to the Example 3 and the content of an α-phase was determined, it was 0%. This value is superior to those of the below-mentioned substitution-type ε-iron oxide magnetic particle powders obtained in Comparative Examples 4 and 5 in which the addition of the ammonia solution was stopped after adding the ammonia aqueous solution until the pH reached 4.0 or 6.0 (first neutralization step), and an intermediate aging step was provided for 30 minutes, and thereafter, the addition of TEOS was started, but the second neutralization step was not provided after completion of the addition of TEOS. Further, the chemical analysis of the composition and the evaluation of the magnetic characteristics were performed. The measurement results are also shown in Table 2.

### [Example 4]

In a 1 L reaction vessel, 104.81 g of a ferric (III) sulfate solution having an Fe concentration of 11.65 mass%, 14.32 g of a Ga(III) nitrate solution having a Ga concentration of 11.55 mass%, 1.91 g of cobalt(II) nitrate hexahydrate with a purity of 97%, and 2.02 g of titanium(IV) sulfate having a Ti concentration of 15.1 mass% were dissolved in 737.71 g of pure water while mechanically stirring with a stirring blade in the air atmosphere (procedure 1). The pH of the resulting solution was about 1. The molar ratio of metal ions in the prepared solution is as follows: Fe:Ga:Co:Ti = 1.714:0.186:0.050:0.050.

While mechanically stirring the prepared solution with a stirring blade under the condition of 30°C in the air atmosphere, 15.00 g of a 22.30 mass% ammonia aqueous solution was added thereto over 1.9 minutes (first neutralization step), and after completion of the dropwise addition, stirring was continued for 30 minutes to age the formed precipitate (intermediate aging step). At that time, the pH of the slurry containing the precipitate was 2.0 (procedure 2) .

While stirring the slurry obtained by the procedure 2, 158.88 g of tetraethoxysilane (TEOS) with a purity of 95.0 mass% was added dropwise thereto over 10 minutes at 30°C in the air. After completion of the addition of TEOS, 62.77 g of a 22.30 mass% ammonia solution was added thereto over 8.1 minutes (second neutralization step). The pH after the second neutralization step was 8.8. Thereafter, stirring was continued as such for 20 hours, thereby coating the precipitate with the chemical reaction product of the silicon compound (procedure 3). The pH of the reaction solution during the stirring for 20 hours was 8.8. Note that under the conditions, the molar ratio of the amount of Si element contained in tetraethoxysilane added to the dispersion liquid with a pH of 2.0 or higher and 7.0 or lower to the amount of iron, gallium, cobalt, and titanium ions contained in the raw material solution, S1/(F+M), is 2.84, and the molar ratio of the total amount of Si element contained in tetraethoxysilane added dropwise to the dispersion liquid to the amount of iron, gallium, cobalt, and titanium ions contained in the raw material solution, S2/(F+M), is also 2.84.

Thereafter, a substitution-type ε-iron oxide magnetic particle powder was obtained by the same procedure as in Example 1. When XRD measurement was performed for the substitution-type ε-iron oxide powder according to the Example 4 and the content of an α-phase was determined, it was 0%. This value is superior to those of the below-mentioned substitution-type ε-iron oxide magnetic particle powders obtained in Comparative Examples 4 and 5. Further, the chemical analysis of the composition and the evaluation of the magnetic characteristics were performed. The measurement results are also shown in Table 2.

### [Example 5]

As Example 5, a substitution-type ε-iron oxide magnetic particle powder was obtained by the same procedure as in Example 4 except that the addition amount and addition time of the ammonia aqueous solution used in the first neutralization step were set to 51.00 g and 6.5 minutes, respectively, the pH after the first neutralization step was set to 3.0, and the addition amount and addition time of the ammonia solution used in the second neutralization step were set to 27.24 g and 3.5 minutes, respectively. Note that the pH of the reaction solution at the completion of the second neutralization step and the pH of the reaction solution during the stirring for 20 hours were both 8.8. When XRD measurement was performed for the substitution-type ε-iron oxide magnetic particle powder according to the Example 5 and the content of an α-phase was determined, it was 0%. This value is superior to those of the below-mentioned substitution-type ε-iron oxide magnetic particle powders obtained in Comparative Examples 4 and 5. Further, the chemical analysis of the composition and the evaluation of the magnetic characteristics were performed. The measurement results are also shown in Table 2.

### [Example 6]

As Example 6, a substitution-type ε-iron oxide magnetic particle powder was obtained by the same procedure as in Example 4 except that the addition amount and addition time of the ammonia aqueous solution used in the first neutralization step were set to 53.00 g and 6.8 minutes, respectively, the pH after the first neutralization step was set to 4.0, and the addition amount and addition time of the ammonia solution used in the second neutralization step were set to 24.78 g and 3.2 minutes, respectively. Note that the pH of the reaction solution after the second neutralization step and the pH of the reaction solution during the stirring for 20 hours were 8.8. When XRD measurement was performed for the substitution-type ε-iron oxide powder according to the Example 5 and the content of an α-phase was determined, it was 0%. This value is superior to those of the below-mentioned substitution-type ε-iron oxide magnetic particle powders obtained in Comparative Examples 4 and 5. Further, the chemical analysis of the composition and the evaluation of the magnetic characteristics were performed. The measurement results are also shown in Table 2.

### [Example 7]

In a 1 L reaction vessel, 102.73 g of a ferric (III) sulfate solution having an Fe concentration of 11.65 mass%, 10.74 g of aluminum(III) nitrate nonahydrate with a purity of 98%, 1.91 g of cobalt (II) nitrate hexahydrate with a purity of 97%, and 2.02 g of titanium(IV) sulfate having a Ti concentration of 15.1 mass% were dissolved in 746.26 g of pure water while mechanically stirring with a stirring blade in the air atmosphere (procedure 1) . The pH of the resulting solution was about 1. The molar ratio of metal ions in the prepared solution is as follows: Fe:Al:Co:Ti = 1.680:0.220:0.050:0.050.

While mechanically stirring the prepared solution with a stirring blade under the condition of 30°C in the air atmosphere, 51.59 g of a 22.30 mass% ammonia aqueous solution was added thereto over 60 minutes (first neutralization step), and after completion of the dropwise addition, stirring was continued for 10 minutes to age the formed precipitate (intermediate aging step). At that time, the pH of the slurry containing the precipitate was 3.0 (procedure 2).

While stirring the slurry obtained by the procedure 2, 158.88 g of tetraethoxysilane (TEOS) with a purity of 95.0 mass% was added dropwise thereto over 5 minutes at 30°C in the air. After completion of the addition of TEOS, 27.09 g of a 22.30 mass% ammonia solution was added thereto over 14 minutes (second neutralization step). The pH after the second neutralization step was 8.8. Thereafter, stirring was continued as such for 20 hours, thereby coating the precipitate with the chemical reaction product of the silicon compound (procedure 3). The pH of the reaction solution during the stirring for 20 hours was 8.8. Note that under the conditions, the molar ratio of the amount of Si element contained in tetraethoxysilane added to the dispersion liquid with a pH of 2.0 or higher and 7.0 or lower to the amount of iron, aluminum, cobalt, and titanium ions contained in the raw material solution, S1/(F+M), is 2.84, and the molar ratio of the total amount of Si element contained in tetraethoxysilane added dropwise to the dispersion liquid to the amount of iron, aluminum, cobalt, and titanium ions contained in the raw material solution, S2/(F+M), is 2.84.

Thereafter, a substitution-type ε-iron oxide magnetic particle powder was obtained by the same procedure as in Example 1. When XRD measurement was performed for the substitution-type ε-iron oxide powder according to the Example 7 and the content of an α-phase was determined, it was 0%. This value is superior to those of the below-mentioned substitution-type ε-iron oxide magnetic particle powders obtained in Comparative Examples 4 and 5. Further, the chemical analysis of the composition and the evaluation of the magnetic characteristics were performed. The measurement results are also shown in Table 2.

With respect to the obtained substitution-type ε-iron oxide magnetic particle powder, the electromagnetic wave absorption characteristics were measured by the above-mentioned method. As a result, the maximum absorption frequency of the green compact in a frequency range from 50 GHz to 100 GHz was 80.1 GHz, and the transmission attenuation per unit thickness was 4.1 dB/mm.

### [Comparative Example 4]

As Comparative Example 4, a substitution-type ε-iron oxide powder was obtained by the same procedure as in Example 6 except that the second neutralization step was not performed. Note that the pH of the reaction solution at the completion of the addition of TEOS and the pH of the reaction solution during the stirring for 20 hours were 4.0. When XRD measurement was performed for the substitution-type ε-iron oxide magnetic particle powder according to the Comparative Example 4 and the content of an α-phase was determined, it was 87.5%, which was a higher value than those of Examples 1 to 7. Further, the chemical analysis of the composition and the evaluation of the magnetic characteristics were performed. The measurement results are also shown in Table 2.

### [Comparative Example 5]

As Comparative Example 5, a substitution-type ε-iron oxide magnetic particle powder was obtained by the same procedure as in Comparative Example 4 except that the addition amount and addition time of the ammonia aqueous solution used in the first neutralization step were set to 57.00 g and 7.3 minutes, respectively, and the pH at the completion of the first neutralization step was set to 6.0. Note that the pH of the reaction solution at the completion of the addition of TEOS and the pH of the reaction solution during the stirring for 20 hours were 6.0. When XRD measurement was performed for the substitution-type ε-iron oxide magnetic particle powder according to the Comparative Example 5 and the content of an α-phase was determined, it was 36.9%, which was a higher value than those of Examples 1 to 7. Further, the chemical analysis of the composition and the evaluation of the magnetic characteristics were performed. The measurement results are also shown in Table 2.

From the above results, it is found that unless the second neutralization step is provided, a substitution-type ε-iron oxide magnetic particle powder having a low α-phase content cannot be obtained. Further, even when either of a nitrate and a sulfate is used as the iron raw material of the starting material, substantially the same results are obtained.

### [Example 8]

A substitution-type ε-iron oxide magnetic particle powder was obtained by the same procedure as in Example 5 except that the stirring time in the intermediate aging step was set to 10 minutes, and tetraethoxysilane (TEOS) was added over 5 minutes. Note that the pH of the reaction solution at the completion of the addition of TEOS was 3.0, and the pH of the reaction solution during the stirring for 20 hours was 8.6.

The content of an α-phase in the obtained substitution-type ε-iron oxide magnetic particle powder was 0%, and the electromagnetic wave absorption characteristics were measured by the above-mentioned method. As a result, the maximum absorption frequency of the green compact in a frequency range from 50 GHz to 100 GHz was 67.2 GHz, and the transmission attenuation per unit thickness was 4.6 dB/mm.

### [Comparative Example 6]

In a 5 L reaction vessel, 527.22 g of a ferric (III) sulfate solution having an Fe concentration of 11.58 mass%, 71.61 g of a Ga(III) nitrate solution having a Ga concentration of 11.55 mass%, 9.57 g of cobalt(II) nitrate hexahydrate with a purity of 97%, and 10.11 g of titanium(IV) sulfate having a Ti concentration of 15.1 mass% were dissolved in 3,688.56 g of pure water while mechanically stirring with a stirring blade in the air atmosphere (procedure 1). The pH of the resulting solution was about 1. The molar ratio of metal ions in the prepared solution is as follows: Fe:Ga:Co:Ti = 1.714:0.186:0.050:0.050.

While mechanically stirring the prepared solution with a stirring blade under the condition of 30°C in the air atmosphere, 388.91 g of a 22.30 mass% ammonia aqueous solution was added thereto over 10 minutes (first neutralization step), and after completion of the dropwise addition, stirring was continued for 30 minutes to age the formed precipitate (intermediate aging step). At that time, the pH of the slurry containing the precipitate was 8.6 (procedure 2).

While stirring the slurry obtained by the procedure 2, 794.40 g of tetraethoxysilane (TEOS) with a purity of 95.0 mass% was added dropwise thereto over 10 minutes at 30°C in the air. Thereafter, stirring was continued as such for 20 hours, thereby coating the precipitate with the chemical reaction product of the silicon compound (procedure 3). The pH of the reaction solution during the stirring for 20 hours was 8.6. Note that under the conditions, the molar ratio of the amount of Si element contained in tetraethoxysilane added to the dispersion liquid with a pH of 2.0 or higher and 7.0 or lower to the amount of iron, gallium, cobalt, and titanium ions contained in the raw material solution, S1/(F+M), is 0, and the molar ratio of the total amount of Si element contained in tetraethoxysilane added dropwise to the dispersion liquid to the amount of iron, gallium, cobalt, and titanium ions contained in the raw material solution, S2/(F+M), is 2.84.

Thereafter, a substitution-type ε-iron oxide magnetic particle powder was obtained by the same procedure as in Example 1. When XRD measurement was performed for the substitution-type ε-iron oxide powder according to the Comparative Example 6 and the content of an α-phase was determined, it was 4.9%, which was a higher value than that of Example 8. Further, the chemical analysis of the composition and the evaluation of the magnetic characteristics and the electromagnetic wave absorption characteristics were performed. The measurement results are also shown in Table 2.

### [Example 9]

A substitution-type ε-iron oxide powder was obtained by the same procedure as in Example 7 except that 101.50 g of a ferric(III) sulfate solution and 11.7 g of aluminum(III) nitrate nonahydrate were used. Note that the pH of the reaction solution at the completion of the addition of TEOS was 3.0, and the pH of the reaction solution during the stirring for 20 hours was 8.6. The molar ratio of metal ions in the prepared solution is as follows: Fe:Al:Co:Ti = 1.660:0.240:0.050:0.050. The chemical analysis of the composition and the evaluation of the magnetic characteristics and the electromagnetic wave absorption characteristics were performed. The measurement results are also shown in Table 2.

### [Comparative Example 7]

In a 1 L reaction vessel, 101.51 g of a ferric(III) sulfate solution having an Fe concentration of 11.65 mass%, 11.72 g of aluminum(III) nitrate nonahydrate with a purity of 98%, 1.91 g of cobalt(II) nitrate hexahydrate with a purity of 97%, and 2.12 g of titanium(IV) sulfate having a Ti concentration of 15.1 mass% were dissolved in 746.36 g of pure water while mechanically stirring with a stirring blade in the air atmosphere (procedure 1). The pH of the resulting solution was about 1. The molar ratio of metal ions in the prepared solution is as follows: Fe:Al:Co:Ti = 1.660:0.240:0.050:0.050.

While mechanically stirring the prepared solution with a stirring blade under the condition of 30°C in the air atmosphere, 78.68 g of a 22.30 mass% ammonia aqueous solution was added thereto over 10 minutes (first neutralization step), and after completion of the dropwise addition, stirring was continued for 30 minutes to age the formed precipitate (intermediate aging step). At that time, the pH of the slurry containing the precipitate was 8.6 (procedure 2).

While stirring the slurry obtained by the procedure 2, 158.88 g of tetraethoxysilane (TEOS) with a purity of 95.0 mass% was added dropwise thereto over 10 minutes at 30°C in the air. Thereafter, stirring was continued as such for 20 hours, thereby coating the precipitate with the chemical reaction product of the silicon compound (procedure 3). The pH of the reaction solution during the stirring for 20 hours was 8.6. Note that under the conditions, the molar ratio of the amount of Si element contained in tetraethoxysilane added to the dispersion liquid with a pH of 2.0 or higher and 7.0 or lower to the amount of iron, gallium, cobalt, and titanium ions contained in the raw material solution, S1/(F+M), is 0, and the molar ratio of the total amount of Si element contained in tetraethoxysilane added dropwise to the dispersion liquid to the amount of iron, gallium, cobalt, and titanium ions contained in the raw material solution, S2/(F+M), is 2.84.

Thereafter, a substitution-type ε-iron oxide magnetic particle powder was obtained by the same procedure as in Example 1. When XRD measurement was performed for the substitution-type ε-iron oxide powder according to the Comparative Example 7 and the content of an α-phase was determined, it was 8.7%, which was a higher value than that of additional Example 2. Further, the chemical analysis and the evaluation of the magnetic characteristics and the electromagnetic wave absorption characteristics were performed. The measurement results are also shown in Table 2.

### [Comparative Example 8]

This Comparative Example is an experimental example corresponding to a conventional production method using the compositional ratio of Example 7.

A substitution-type ε-iron oxide magnetic particle powder was obtained by the same procedure as in additional Comparative Example 2 except that the amounts of metal salts added were changed as follows: a ferric (III) sulfate solution having an Fe concentration of 11.65 mass%: 102.73 g, and aluminum(III) nitrate nonahydrate with a purity of 98%: 10.74 g.

Note that the pH of the reaction solution at the completion of the addition of TEOS and the pH of the reaction solution during the stirring for 20 hours were both 8.6. When XRD measurement was performed for the substitution-type ε-iron oxide magnetic particle powder according to the Comparative Example and the content of an α-phase was determined, it was 8.1%, which was a higher value than that of Example 7. Further, the chemical analysis of the composition and the evaluation of the magnetic characteristics were performed. The measurement results are also shown in Table 2.

### [Table 1]

**Table 1**

| | Supply source of iron ion | Prenaration composition (molar ratio) | | | | | Raw material solution | | Intermediate aging (min) | Addition of TEOS | | | pH during aging | S1/ (F+M) | S2/ (F+M) |
|---|---|---|---|---|---|---|---|---|---|---|---|---|---|---|---|
| | | Fe | Ga | Al | Co | Ti | pH | Temperature (°C) | | pH at starting | Addition time (min) | pH at completion | | | |
| Example 1 | nitrate | 1.677 | 0.223 | - | 0.050 | 0.050 | 1.25 | 20 | | 4.0 | 30 | 8.8 | 8.8 | 0.34 | 2.84 |
| Example 2 | nitrate | 1.677 | 0.223 | - | 0.050 | 0.050 | 1.25 | 30 | | 6.0 | 30 | 8.8 | 8.8 | 0.018 | 2.84 |
| Comparative Example 1 | nitrate | 1.677 | 0.223 | - | 0.050 | 0.050 | 1.25 | 20 | 30 | 8.9 | 30 | 8.8 | 8.8 | 0 | 2.84 |
| Comparative Example 2 | nitrate | 1.677 | 0.223 | - | 0.050 | 0.050 | 1.25 | 25 | 30 | 8.9 | 30 | 8.8 | 8.8 | 0 | 2.84 |
| Comparative Example 3 | nitrate | 1.677 | 0.223 | - | 0.050 | 0.050 | 1.25 | 30 | 30 | 8.9 | 30 | 8.8 | 8.8 | 0 | 2.84 |
| Example 3 | nitrate | 1.714 | 0.223 | - | 0.050 | 0.050 | 1.25 | 20 | | 4.0 | 30 | 4.0 | 8.8 | 2.84 | 2.84 |
| Example 4 | sulfate | 1.714 | 0.186 | - | 0.050 | 0.050 | 1.15 | 30 | 30 | 2.0 | 10 | 2.0 | 8.8 | 2.84 | 2.84 |
| Example 5 | sulfate | 1.714 | 0.186 | - | 0.050 | 0.050 | 1.15 | 30 | 30 | 3.0 | 10 | 3.0 | 8.8 | 2.84 | 2.84 |
| Example 6 | sulfate | 1.714 | 0.186 | - | 0.050 | 0.050 | 1.15 | 30 | 30 | 4.0 | 10 | 4.0 | 8.8 | 2.84 | 2.84 |
| Example 7 | sulfate | 1.680 | - | 0.220 | 0.050 | 0.050 | 1.15 | 30 | 10 | 3.0 | 5 | 3.0 | 8.8 | 2.84 | 2.84 |
| Comparative Example 4 | sulfate | 1.714 | 0.186 | - | 0.050 | 0.050 | 1.15 | 30 | 30 | 4.0 | 10 | 4.0 | 4.0 | 2.84 | 2.84 |
| Comparative Example 5 | sulfate | 1.714 | 0.186 | - | 0.050 | 0.050 | 1.15 | 30 | 30 | 6.0 | 10 | 6.0 | 6.0 | 2.84 | 2.84 |
| Example 8 | sulfate | 1.714 | 0.186 | - | 0.050 | 0.050 | 1.15 | 30 | 10 | 3.0 | 5 | 3.0 | 8.6 | 2.84 | 2.84 |
| Comparative Example 6 | sulfate | 1.714 | 0.186 | - | 0.050 | 0.050 | 1.15 | 30 | 30 | 8.6 | 10 | 8.6 | 8.6 | 0 | 2.84 |
| Example 9 | sulfate | 1.660 | - | 0.240 | 0.050 | 0.050 | 1.15 | 30 | 10 | 3.0 | 5 | 3.0 | 8.6 | 2.84 | 2.84 |
| Comparative Example 7 | sulfate | 1.660 | - | 0.240 | 0.050 | 0.050 | 1.15 | 30 | 30 | 8.6 | 10 | 8.6 | 8.6 | 0 | 2.84 |
| Comparative Example 8 | sulfate | 1.680 | - | 0.220 | 0.050 | 0.050 | 1.15 | 30 | 30 | 8.6 | 10 | 8.6 | 8.6 | 0 | 2.84 |

### [Table 2]

**Table 2**

| | Composition (molar ratio) | | | | | Me/ (Fe+Me) | α-phase content (%) | BET specific surface area (m²/g) | Magnetic characteristics | | Average particle diameter (nm) | Electromagnetic wave absorption characteristics | |
|---|---|---|---|---|---|---|---|---|---|---|---|---|---|
| | Fe | Ga | Al | Co | Ti | | | | Hc (kA/m) | σs (Am²/kg) | | Maximum absorption frequency (GHz) | Transmission attenuation (dB/mm) |
| Example 1 | 1.693 | 0.205 | - | 0.051 | 0.051 | 0.153 | 1.3 | 49.0 | 357 | 17.3 | 23.8 | | |
| Example 2 | 1.689 | 0.210 | - | 0.050 | 0.050 | 0.155 | 3.0 | 51.0 | 356 | 17.3 | 24.4 | | |
| Comparative Example 1 | 1.699 | 0.205 | - | 0.048 | 0.047 | 0.150 | 3.6 | 55.2 | 367 | 16.9 | 21.6 | | |
| Comparative Example 2 | 1.696 | 0.204 | - | 0.050 | 0.050 | 0.152 | 7.4 | 51.4 | 357 | 17.0 | 23.6 | | |
| Comparative Example 3 | 1.696 | 0.203 | - | 0.051 | 0.050 | 0.152 | 5.4 | 59.5 | 354 | 16.6 | 20.9 | | |
| Example 3 | 1.691 | 0.207 | - | 0.051 | 0.051 | 0.155 | 0 | 51.2 | 365 | 17.6 | 22.5 | | |
| Example 4 | 1.719 | 0.171 | - | 0.061 | 0.049 | 0.141 | 0 | 48.4 | 366 | 17.5 | 19.8 | | |
| Example 5 | 1.715 | 0.171 | - | 0.061 | 0.049 | 0.142 | 0 | 54.9 | 338 | 17.3 | 18.7 | | |
| Example 6 | 1.715 | 0.172 | - | 0.060 | 0.052 | 0.142 | 0 | 52.3 | 352 | 17.4 | 25.1 | | |
| Example 7 | 1.689 | - | 0.204 | 0.047 | 0.060 | 0.155 | 0 | 47.9 | 411 | 15.5 | 25.5 | 80.1 | 4.1 |
| Comparative Example 4 | 1.765 | 0.168 | - | 0.064 | 0.003 | 0.117 | 87.5 | 25.2 | 416 | 2.3 | 24.8 | | |
| Comparative Example 5 | 1.765 | 0.172 | - | 0.061 | 0.003 | 0.118 | 36.9 | 29.6 | 730 | 7.4 | 26.5 | | |
| Example 8 | 1.715 | 0.173 | - | 0.060 | 0.053 | 0.143 | 0 | 49.3 | 352 | 17.1 | 21.7 | 67.2 | 4.6 |
| Comparative Example 6 | 1.726 | 0.165 | - | 0.059 | 0.050 | 0.137 | 4.9 | 50.8 | 355 | 17.0 | 21.1 | 76.3 | 3.3 |
| Example 9 | 1.680 | - | 0.209 | 0.060 | 0.051 | 0.160 | 0 | 48.3 | 378 | 15.7 | 23.4 | 75.8 | 3.9 |
| Comparative Example 7 | 1.670 | - | 0.216 | 0.061 | 0.053 | 0.165 | 8.7 | 46.4 | 339 | 14.4 | 24.6 | 76.8 | 2.4 |
| Comparative Example 8 | 1.692 | - | 0.195 | 0.061 | 0.052 | 0.154 | 8.1 | 50.5 | 359 | 14.5 | 22.9 | 79.6 | 2.7 |

## Claims

1. A substitution-type ε-iron oxide magnetic particle powder, mainly comprising an ε-type iron-based oxide in which the Fe sites of ε-Fe₂O₃ are partially substituted by another metal element, wherein when the number of moles of Fe contained in the substitution-type ε-iron oxide magnetic particle powder is represented by Fe and the number of moles of all metal elements substituted for the Fe sites is represented by Me, the substitution amount of Fe by the another metal element defined by Me/(Fe+Me) is 0.08 or more and 0.17 or less, and the content of an α-type iron-based oxide measured by X-ray diffractometry is 3% or less.

2. The substitution-type ε-iron oxide magnetic particle powder according to claim 1, wherein the another metal element that partially substitutes the Fe sites is Co, Ti, and one or more types selected from Ga and Al.

3. A green compact, comprising the substitution-type ε-iron oxide magnetic particle powder according to claim 1 or 2.

4. An electromagnetic wave absorber, comprising the substitution-type ε-iron oxide magnetic particle powder according to claim 1 or 2 dispersed in a resin or rubber.

5. A method for producing a substitution-type ε-iron oxide magnetic particle powder mainly containing an ε-type iron-based oxide in which the Fe sites of ε-Fe₂O₃ are partially substituted by another metal element, the method comprising:
a neutralization step of obtaining a dispersion liquid containing an iron oxyhydroxide having a substituent metal element or a mixture of an iron oxyhydroxide and a hydroxide of a substituent metal element using an acidic aqueous solution containing a trivalent iron ion and an ion of a metal that partially substitutes the Fe sites as a raw material solution by adding an alkali to the raw material solution so as to neutralize the solution to a pH of 8.0 or higher and 10.0 or lower;
a silicon compound addition step of adding a silicon compound having a hydrolyzable group to the dispersion liquid containing the iron oxyhydroxide having a substituent metal element or the mixture of the iron oxyhydroxide and the hydroxide of a substituent metal element; and
an aging step of coating the iron oxyhydroxide having a substituent metal element or the mixture of the iron oxyhydroxide and the hydroxide of a substituent metal element with a chemical reaction product of the silicon compound by holding the dispersion liquid containing the iron oxyhydroxide having a substituent metal element or the mixture of the iron oxyhydroxide and the hydroxide of a substituent metal element, and the silicon compound at a pH of 8.0 or higher and 10.0 or lower, wherein
the addition of the silicon compound having a hydrolyzable group is started when the pH of the dispersion liquid in the neutralization step has reached 2.0 or higher and 7.0 or lower,
when the number of moles of the silicon compound to be added to the dispersion liquid with a pH of 2.0 or higher and 7.0 or lower is represented by S1, the number of moles of Fe ions contained in the raw material solution is represented by F, and the total number of moles of substituent metal element ions therein is represented by M, S1/(F+M) is 0.01 or more and 10.0 or less, and
when the total number of moles of the silicon compound added is represented by S2, S2/(F+M) is 0.50 or more and 10.0 or less.

6. The method for producing a substitution-type ε-iron oxide magnetic particle powder according to claim 5, wherein the addition of the alkali in the neutralization step and the addition of the silicon compound in the silicon compound addition step are both performed continuously.

7. The method for producing a substitution-type ε-iron oxide magnetic particle powder according to claim 5, wherein the addition of the alkali in the neutralization step is performed continuously and the addition of the silicon compound in the silicon compound addition step is performed intermittently.

8. The method for producing a substitution-type ε-iron oxide magnetic particle powder according to claim 5, wherein the addition of the alkali in the neutralization step and the addition of the silicon compound in the silicon compound addition step are both performed intermittently.

9. The method for producing a substitution-type ε-iron oxide magnetic particle powder according to claim 5, wherein the addition of the alkali in the neutralization step is performed intermittently and the addition of the silicon compound in the silicon compound addition step is performed continuously.

10. The method for producing a substitution-type ε-iron oxide magnetic particle powder according to claim 5, wherein the another metal element that partially substitutes the Fe sites is Co, Ti, and one or more types selected from Ga and Al.

11. A method for producing a green compact, comprising compression-molding the substitution-type ε-iron oxide magnetic particle powder according to claim 1 or 2, thereby obtaining a green compact.
